Europäisches Patentamt

European Patent Office

Office européen des brevets

(19)

(11) Publication number: **0 104 922**

**B1**

(12) **EUROPEAN PATENT SPECIFICATION**

(45) Date of publication of patent specification: 22.06.88

(51) Int. Cl.⁴: **H 01 J 37/317, H 01 J 37/302**

(21) Application number: 83305721.9

(22) Date of filing: 26.09.83

(54) Electron beam exposure system.

(30) Priority: 27.09.82 JP 167919/82

(43) Date of publication of application:
04.04.84 Bulletin 84/14

(45) Publication of the grant of the patent:
22.06.88 Bulletin 88/25

(84) Designated Contracting States:
DE FR GB

(56) References cited:
EP-A-0 053 225

IEDM TECHNICAL DIGEST - INTERNATIONAL ELECTRON DEVICES MEETING, 8th-10th December 1980, Washington, D.C., pages 425-428, IEEE, New York, US; Y. SAKAKIBARA et al.: "Electron-beam direct writing technology for 1 mum VLSI fabrication"

(73) Proprietor: FUJITSU LIMITED
1015, Kamikodanaka Nakahara-ku
Kawasaki-shi Kanagawa 211 (JP)

(72) Inventor: Yasuda, Hiroshi c/o Fujitsu Limited
Patent Department 1015 Kamikodanaka
Nakahara-ku Kawasaki 211 (JP)
Inventor: Tsuchikawa, Haruo c/o Fujitsu Limited
Patent Department 1015 Kamikodanaka
Nakahara-ku Kawasaki 211 (JP)
Inventor: Kai, Junichi c/o Fujitsu Limited
Patent Department 1015 Kamikodanaka
Nakahara-ku Kawasaki 211 (JP)
Inventor: Kobayashi, Koichi c/o Fujitsu Limited
Patent Department 1015 Kamikodanaka
Nakahara-ku Kawasaki 211 (JP)

(74) Representative: Sunderland, James Harry et al
HASELTINE LAKE & CO Hazlitt House 28
Southampton Buildings Chancery Lane
London WC2A 1AT (GB)

Courier Press, Leamington Spa, England.

## Description

The present invention relates to an electron beam exposure system.

Electron beam exposure is used to generate or expose extremely fine patterns on the substrates of integrated circuits (IC). Several types of electron beam exposure have been proposed. Examples are a Gaussian beam type (using an electron beam whose cross sectional beam current density has a Gaussian distribution), a shaped beam type (especially a rectangular beam type) and a variable beam type.

There has been a gradual tendency towards an electron beam exposer with a constant beam density and variable beam size or variable beam shape, because this type of exposer can provide sharper pattern edges, and uniform beam irradiation over a pattern.

Processing speed is also very important in practice. It is determined by the time necessary for a beam to irradiate the whole of a substrate.

To reduce processing time it is necessary to increase beam current density and the beam size, but both are limited by beam blurring (beam sharpness). It is thus desirable to use the maximum beam size allowable, consistent with the required accuracy. Different IC die patterns have different accuracy requirements so it is very desirable to change beam size from pattern to pattern.

The word "pattern" is used sometimes to refer to a figure of an IC circuit which is to be formed or composed on an IC die or chip. Sometimes it is used to refer to a component of such figures (generally it is rectangles—generally the components are rectangular in shape) by which the shapes or figures of an IC circuit are composed.

It is general in electron beam technology to use the word 'pattern' with the latter meaning. Hereinafter, therefore, 'pattern' should be understood to refer to a component of figures (rectangles) by which the IC circuit is composed. That is, the whole of an IC circuit can be divided into rectangular patterns, and those patterns are exposed one by one, using an electron beam. Of course there are large numbers of patterns, including very small patterns which can each be exposed in only one shot (sometimes one explosion of an electron beam is called a shot) of electron beam exposure, and large patterns which need large numbers repetitions of exposure and stepping of the electron beam in order to expose the whole area of the pattern.

The term "step and expose" and "step and shot" will also be explained. These terms have the same meaning and refer to a process that is used to expose a pattern larger than the beam size by exposing then shifting the beam by a pitch equal to the beam size, then exposing again and so on until whole area of a pattern is exposed.

Those terms should be distinguished from the term "step and repeat", which refers to the exposure of patterns on one die then stepping to a next die and exposing the same patterns on the next die, and repeating, on the same IC slice.

As the scale of integration has increased, the number of patterns to be exposed in a die has increased to a few millions, and the number of shots (explosions) necessary to expose those patterns has reached more than ten million. Improvement in process speed is therefore urgently required, to increase the throughput of electron beam exposure systems.

Previously, beam size control has been very difficult and consequently electron beam exposure has been performed with a constant sized beam, the size determined by the finest pattern required on a die. It has thus taken a long time to expose all the patterns on a slice.

In a step and expose method, pattern size, beam size and pitch are given, and the beam is controlled by computers. Programming the computers for the millions of patterns required has been a problem. However, with given pattern size and position, computers have been proposed which can divide the pattern into rectangles equal to the beam size enabling the exposure of the whole area of a pattern by step and expose repeats along the alignment of the rectangles. Although the necessary calculations for each pattern can be performed in a short time, the computer must carry out such calculations millions of times to enable the exposure of all the patterns on a slice. The total time required for the calculations for millions of patterns is very long.

The electron beam exposure process is becoming a bottleneck for LSI (large scale integrated circuit) manufacturing.

According to the present invention there is provided an electron beam exposure system, in which beam size is varied in accordance with different accuracy requirements of different patterns to be exposed, and each pattern is exposed using a maximum permissible beam size therefore, the system comprising:—

a rectangular electron beam exposer provided with

(a) a first mask having a rectangular aperture for restricting an electron stream to form an electron beam having a rectangular cross section;

(b) a first deflector for deflecting the electron beam in accordance with a size signal applied to the first deflector;

(c) a second mask having a rectangular aperture for restricting the electron beam to provide a selected rectangular cross section for the electron beam, corresponding to the size signal applied to the first deflector; and

(d) a second deflector for deflecting the electron beam on a substrate in accordance with position signals applied to the second deflector; and control means operable to provide the electron beam exposer with

(a) the said size signal, in accorance with accuracy required of a pattern to be exposed; and

(b) the said position signal; such that the electron beam exposes patterns sequentially, the electron beam having a maximum beam size permissible for each pattern,

the control means comprising:

(a) buffer memory means which stores pattern information including accuracy information, starting position information and pattern size information for each pattern;

(b) a plurality of memory means each storing pattern data, including pattern size data number data, pitch data, and beam size data;

(c) first means for selecting pattern data stored in said memory means in accordance with said accuracy information and said size information in the buffer memory means, for a pattern to be exposed;

(d) second means providing the said size signal in accordance with beam size data included in the pattern data selected by the first means; and

(e) third means providing the said position signal in accordance with pitch data and number data included in the pattern data selected by the first means and starting position information for the pattern stored in the buffer memory means.

An embodiment of the present invention can provide an electron beam exposure system having sufficient accuracy, and yet providing a high processing speed, suitable for CAD (computer aided design) and CAM (computer aided manufacturing) systems.

For different IC patterns, even though the patterns are composed on the same die or chip, there can be different accuracy requirements. For example, on a slice for LSI, the gate part of a MOSFET (metal oxide semiconductor type field effect transistor) requires the highest accuracy, whilst the pattern of a bonding area to which a wire will be bonded does not require such a high accuracy, and patterns for wiring between the circuit elements require accuracy of an intermediate level.

In order to attain a high processing speed, beam size is adjusted to the maximum size usable for each pattern, corresponding to the accuracy requirement for each pattern.

Incidentally, the blur which an electron beam suffers is roughly proportional to beam current or beam size. Maximum beam size is thus restricted both by the size of the pattern to be exposed and the accuracy requirement of the pattern. As the beam size is varied from pattern to pattern, the pitch of a beam deflection must be also varied.

In an embodiment of the present invention, the pattern is divided into rectangles equal to the maximum beam size as determined by the pattern size or the required accuracy. If division on this basis leaves a residual part, smaller than the rectangles, the rectangle size is adjusted to be a little smaller, but as close as possible to maximum beam size, such that the whole area of the pattern can be divided into equal-size rectangles (without a residual part). The pitch and size of the beam is then adjusted to this adjusted rectangle.

In general such a residual part of area will have different length and breadth dimensions. Thus, the above-mentioned adjustment of beam size is independently effected for those dimensions. The adjusted new beam size is, therefore, slightly smaller than the maximum beam size.

Then, repeated step and expose is effected with this new size adjusted beam. When the exposure of a pattern is completed, the beam begins to expose the next pattern, with a different beam size and pitch as necessary, in the same manner as described above.

Such processing is carried out automatically with the aid of computers. Time for calculating the layout of the beam on the pattern is eliminated, so process time for beam control is further reduced, and the throughput of the electron beam exposure system is increased to a great extent.

Reference is made, by way of example, to the accompanying drawings, in which:—

Figure 1 is a graph illustrating the relationship between blur and electron beam size,

Figure 2 illustrates schematically an example of a pattern, for assistance in explanation of an electron beam exposure method carried out by a system embodying the present invention;

Figure 3 illustrates schematically an example of a part of a pattern for assistance in explanation of step and expose method carried out by a system embodying the present invention;

Figures 4(a) and 4(b) illustrate schematically an end portion of a pattern for assistance in explanation of the exposure of such a portion as effected in embodiments of the present invention;

Figure 5 is a schematic block diagram of an electron beam exposure system embodying the present invention; and

Figure 6 is a table giving an example of pattern data stored in memory means of the system of Figure 5.

As previously mentioned an embodiment of the present invention involves an electron beam exposure system, in which the pattern size of electron beam is adjusted, from pattern to pattern, to a maximum size usable for each pattern, corresponding to the accuracy required by the circuit design.

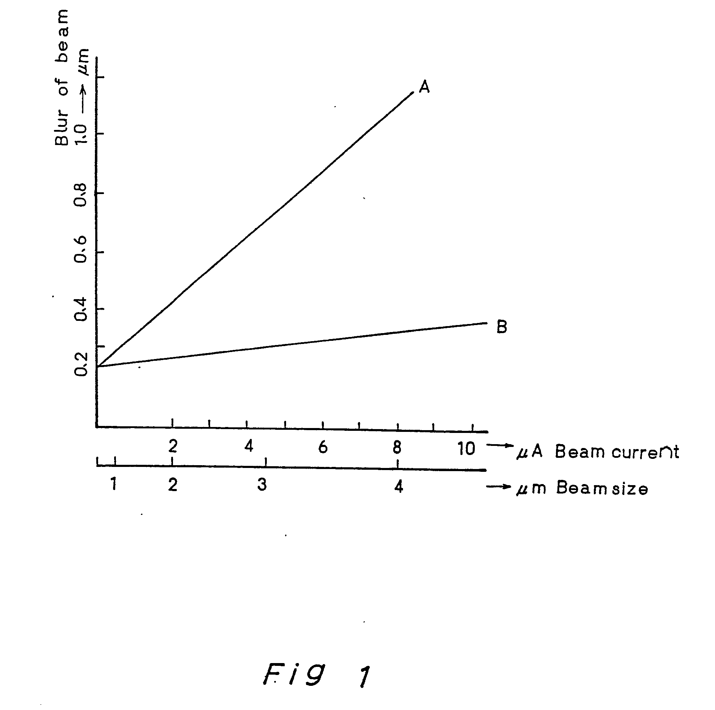

Figure 1 is a graph illustrating the relationship between blur and electron beam size as experimentally determined by the inventors of the present invention, for an electron exposer used for IC processing. As can be seen also in the graph, blur increases approximately in proportion to the beam current. The inventors believe that this might be expected to some extent from theory. Of course, blur increases with electron beam density. The graph relates to blur at a beam current density of 50 A/cm². The blur (that is the sharpness of the beam) is determined by the length at the edge of beam projected on a target wherein the beam density falls from 90% to 10% of its maximum density.

The graph of Figure 1 is derived from measurements taken with an electron beam having a rectangular cross-section. Thus, the abscissa is proportional to the cross sectional area of beam. It will be understood that a beam current of 2 μA on the abscissa of Figure 1, corresponds to a beam size of 2×2 μm², and that 8 μA corresponds to 4×4 μm² and so on, because in the case of Figure 1 the current density is equal to 50 A/cm². In the graph, size is indicated in terms of one side of a square beam.

Curve A in Figure 1 indicates the magnitude of blur versus beam current in an ordinary exposure process. Curve B indicates blur when a refocussing process is applied to the exposer used to derive curve A. As can be seen, a refocussing process can provide a beam almost four times as sharp as that provided by ordinary exposure. That means the refocussing process can provide a beam size almost four times as large as the ordinary exposure (for the same blur), and hence it can provide a process speed almost four times faster. Electron beam refocussing shifts the beam position to some extent, so it is necessary to readjust the beam positioning. A refocussing process has been disclosed in the EP—A— 0 083 246, which is assigned to the present applicant.

Beam sharpness of the best levels indicated in Figure 1 is the best attainable with present exposures. Blurs larger than 1 μm or so are not shown because a pattern of an accuracy of such levels can be generated by optical exposers. Thus an electron beam exposer whose blur is larger than 1 μm is of no practical meaning.

An electron beam exposer used in accordance with an embodiment of the present invention is a variable rectangular cross-sectional beam type exposer. It provides a constant beam current density regardless of variation in beam size, and it is provided with means for carrying out a refocussing process. Details of the exposer will be described hereinafter.

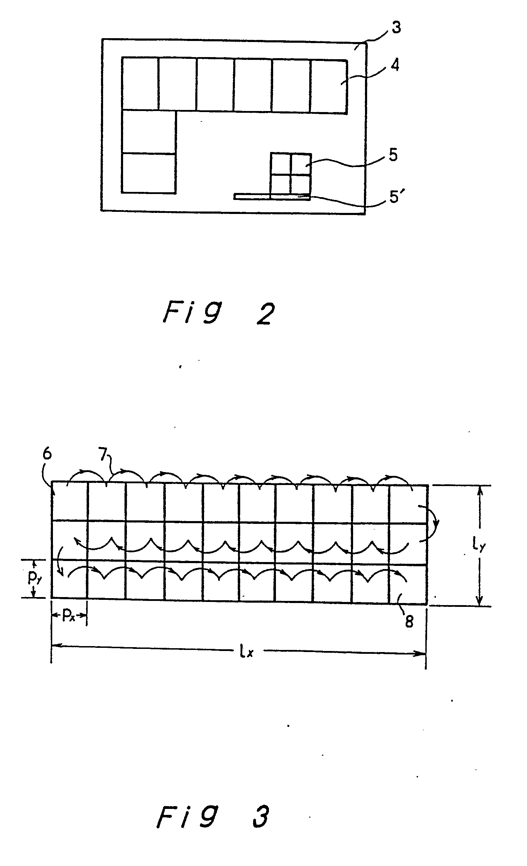

A method of electron beam exposure embodying the present invention will be explained with reference to Figures 2 and 3.

Figure 2 shows schematically examples of patterns 4 and 5 to be exposed on an IC substrate 3. In practice a figure or shape exposed on an IC die will be much more complicated, but Figure 2 serves to illustrate a pattern 4 which is large but for which accuracy is not critical, and a pattern 5 which is fine and requires high accuracy. These requirements are specified by circuit design.

Pattern 4 can be exposed by a large sized beam, but pattern 5 should be exposed by a small sized beam in order to attain the desired accuracy.

For a pattern 5' accuracy is required in its lateral direction (Y or vertical direction in Figure 2) but accuracy in its longitudinal direction (X or horizontal direction) is not so critical. The beam size for pattern 5' is thus limited by the Y direction accuracy requirement.

In any case, a pattern should be exposed with a largest sized beam allowable consistent with the accuracy requirement, in order to complete the exposure process as quickly as possible, and to attain a high system throughput.

When beam size is specified, the whole area of a pattern 6 (see Figure 3) which is to be exposed by the specified beam is divided into rectangles whose size is equal to the specified beam size. For example, let the maximum beam size usable be 1×1, and the pattern size to be exposed by this sized beam be $1_x \times 1_y$ as shown in Figure 3. Further, let X and Y directions correspond to the directions of $1_x$ and $1_y$ in the Figure, respectively. The number of shots $n_x$ needed to cover the whole length of $1_x$ is

$$n_x = 1_x/1 \qquad (1)$$

Usually $1_x$ can not be perfectly divided by 1. If there is a remainder, $n_x$ is moved up to the next larger integer. Then the size and pitch of the beam in the X direction is determined by

$$p_x = 1_x/n_x \qquad (2)$$

In the same manner, the number of shots for covering the whole length $1_y$ and the size and pitch of step in the Y direction are determined as

$$n_y = 1_y/1 \qquad (3)$$
and
$$p_y = 1_y/n_y \qquad (4)$$

respectively. $n_x$ and $n_y$ are integral numbers (integral values nearest above the values determined by (1) and (3)—i.e. if there are any figures after the decimal point in $n_x$ and $n_y$ they are raised to the next unit value).

The described pattern division (layout of shots) can be understood as follows. The whole area of a pattern is first divided into equal sized rectangles whose size is equal to the maximum beam size which is possible with regard to the accuracy requirement for the pattern. If such division leaves a residual part of the pattern smaller than the beam size, the rectangle size is made slightly smaller so as to leave no residual area. It will thus be understood that the new rectangle size is the largest beam size allowable for this area. Exposure is carried out with this new sized beam, repeating a step and expose process as shown by arrows 7 in Figure 3.

It should be noted that the beam size (shape) determined as above is generally almost square, and very close to the specified size 1×1 by the design. However, there are sometimes cases in which the beam has quite different X and Y dimensions.

An example is shown in Figure 2. In that Figure, a fine pattern 5 is exposed with a small and sharp beam just as described above. Beam shape is almost square. However, the portion 5' is different. In this example, the pattern is long in the X direction, but it is very narrow in the Y direction. Greater sharpness is required in the Y direction than in the X direction.

In such a case the beam size is determined by the Y-direction accuracy requirement. In the case of pattern 5' in Figure 2, the width of Y direction is so narrow that a very long beam in the X direction is possible. Only one shot in the Y direction is enough, and the pitch of X direction is adjusted as before.

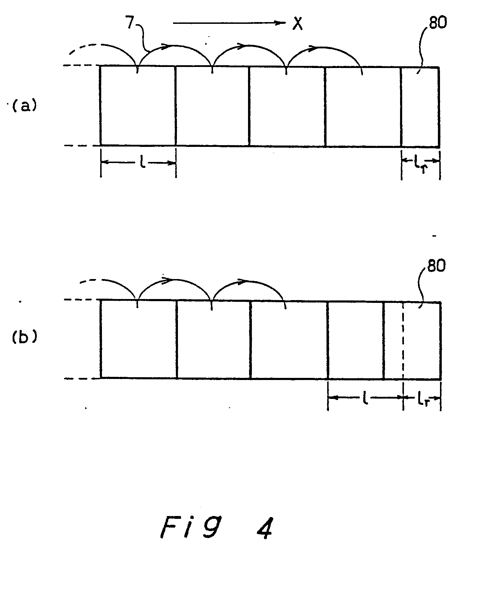

There are two other alternative ways of dealing with residual areas as described above, as will be explained with reference to Figures 4(a) and 4(b). For the sake of simplicity, those Figures show only one exposure line. The Figures show the right end parts of step and repeat exposure processes.

In Figure 4(a), step and expose commences from the left side of the Figure, and repeated exposures are made progressing in the X direction along arrows 7. In this case the beam size is the maximum (1×1) specified by accuracy. At the end of the line there is a residual area 80 which is smaller than the beam size. At this point the beam size is adjusted to cover the residual area with one shot. Namely the size of beam is contracted in the X direction to be equal to a residual length $1_r$.

In Figure 4(b) exposures commence from the left side of the Figure, with the maximum beam size, just as in the case of Figure 4(a). The exposures with that beam size are halted one shot (with maximum beam size) before the residual area 80 is reached. At this point beam size and pitch are adjusted to,

$$1_x = p_x = (1 + 1_r)/2 \qquad (5)$$

and two more exposure shots made.

In both Figure 4(a) and Figure 4(b), explanation has been given only for the residual area processing in the X direction. It will be clear however that beam size can be adjusted in Y direction in just the same manner.

In the above explanation, the figure to be exposed has been taken to be essentially composed of rectangular forms. This is true for ordinary figures occurring for IC and LSI. Thus, the method described above can be very conveniently applied to any IC or LSI production. In the rare case that a pattern includes a curved line or curved edge, the method can be applied by simulating the curve with a plurality of rectangles of appropriate size. This has been done, and the results were satisfactory.

It will be explained how an electron beam exposer is controlled to perform the above described step and expose operations. It will be clear that control is performed easily and quickly by means of a system embodying the present invention.

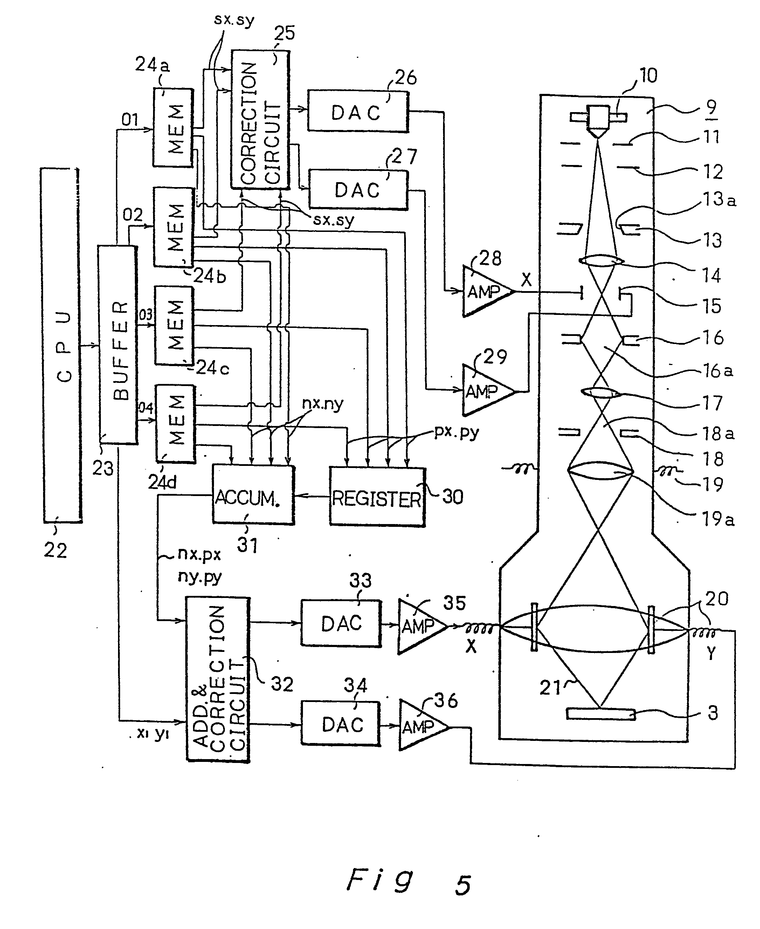

Figure 5 shows a block diagram of an electron beam exposure system embodying the present invention.

In a vacuum chamber of an electron beam exposer 9 there is loaded a target (an IC substrate) 3 on which a pattern is to be exposed.

With regard to the electrodes arranged in the column of the electron beam exposer 9, a cathode 10 emits electrons, the emitted electrons are formed into a beam passing through a grid 11 and an anode 12, and led to a first mask 13, having a rectangular aperture 13a. The electron beam emerging from the aperture has a rectangular cross section.

The rectangular beam from the first aperture 13a is focussed onto a second mask 16 by a first lens 14. The beam is deflected on the second mask, which has a rectangular aperture 16a, by first deflector 15. By deflecting the electron beam on the second mask, the beam emerging from the second aperture 16a can be given any rectangular shape, by means of a control signal (which will be called a size signal hereinafter) applied to the first deflector.

The electron beam shaped to the appropriate rectangular cross section passes through a lens 17 and an electrode 18 having an aperture 18a, and it is focussed by a refocus lens 19a. The beam is refocussed to reduce its blur, and shift of beam position caused by the refocussing process is corrected. A coil 19 performs these corrections, controlled by a computer. Further details of the refocussing are set forth in the EP—A—0 083 246.

An electron beam 21 from the refocus lens 19a is focussed on the target 3 and deflected by a second deflector 20 to expose a pattern on the substrate.

Control means for controlling electrodes of the electron beam exposer will now be described.

A central processing unit (CPU) 22 provides a signal to control the cathode 10 and a blanking electrode (not shown) and so on. However, such signals are not essentially related to the invention, so explanation will be omitted for simplicity. It will be described only how the first and second deflectors are controlled to expose a pattern by a step and expose method.

For example, the system of Figure 5 is part of a CAM (computer aided manufacturing) system, and IC circuit design data to be processed by electron beam exposure is supplied to the CPU 22, from magnetic tape or magnetic disc usually (of course data may be given manually). The design data includes pattern information for all the patterns to be exposed on one IC die in one process. Pattern information includes information concerning accuracy (accuracy information), starting point positioning (starting point information) and pattern size (pattern size information). The information is coded and stored in a buffer-memory means 23 by instructions from the CPU. The buffer-memory 23 may need a capacity of about 40 megabytes.

24a, b, c, and d are memories storing pattern data each corresponding to a grade of accuracy. Pattern data means a data set concerning pattern length (pattern size data in both X and Y directions), number of shots (called number data hereinafter), pitch data, and beam size data. This data is coded and stored in the memories.

For example, memory 24a stores pattern data concerning beam size 4 μm, that is, a large (coarse) sized beam. Memory 24b stores pattern data for beam size 2.5 μm, that is, an intermediate size beam. Memories 23c and 24d store pattern data for fine (accurate) beam sizes 2 μm and 1.6 μm respectively. In this example four grades of accuracy (i.e. beam sizes) are defined:—4, 2.5, 2 and 1.6 μm respectively. Different grades of accuracy can be defined at will (i.e. any beam size can be selected), and the number of grades can be increased at will.

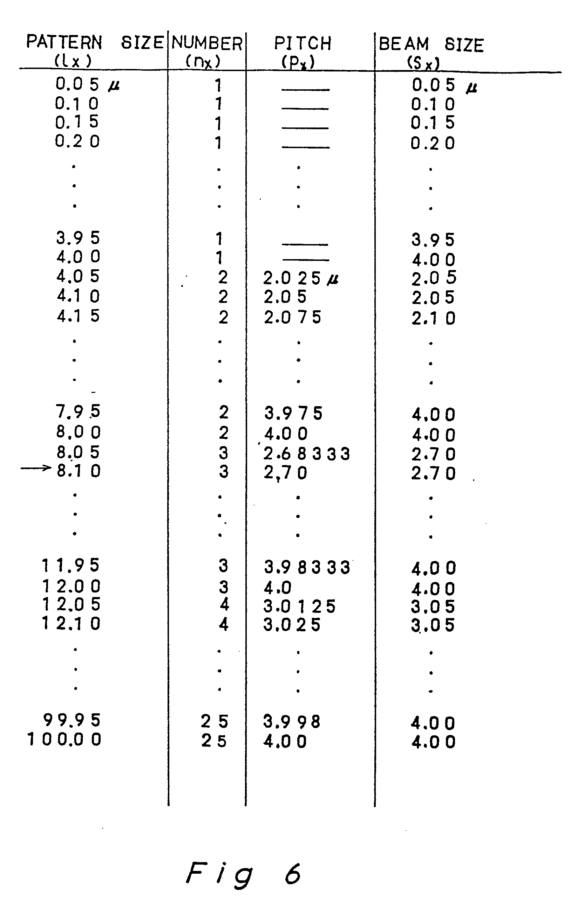

The pattern data in the memories 24 includes all data necessary to expose any pattern in one process. One example of such data relating to a case in which beam size is limited to 4 μm is shown in Figure 6. The Figure indicates how patterns are divided into rectangles equal to beam size. That is a layout of electron beam to expose the pattern. Figure 6 is in the form of a table. In a pattern size ($1_x$) column of the table there are listed pattern lengths in the X direction, the lengths increasing in 0.05 μm steps. These lengths are lengths of pattern to be exposed. The step between the lengths may be altered at will but usually 0.5 μm is sufficient for ordinary applications. In the number ($n_x$) column of the table there are given numbers of shots needed to exposre the pattern lengths ($1_x$) in the pattern column, with pitches $p_x$ and beam sizes $S_x$ as shown in the corresponding columns.

For example, the first line in the table indicates that a pattern with a length 0.05 μm is exposed by a single shot of beam size ($S_x$) 0.05 μm. A pattern with a length 8.10 μm (see the arrowed line in the table) is exposed by three shots with a beam size 2.70 μm and with a pitch ($p_x$) 2.70 μm, and so on.

As can be seen in the table, beam size is limited to 4 μm, so the pattern data given relates to a 4 μm beam (that is the coarsest beam), and it will be seen that patterns up to 4 μm in length (size) are exposed by single shots with beam size smaller than 4 μm, but that patterns larger than 4 μm are exposed by a step and expose process.

The pattern data given in the table of Figure 6 can be calculated easily using equations (1) to (4) above for any size of pattern when accuracy required for the pattern (maximum beam size) and pattern size are given. Such data might be calculated from pattern to pattern while an exposure process is going on but as noted above, if such calculations are carried out during the exposure process the millions of calculations necessary result in a processing delay.

Although the number of patterns to be exposed on an IC circuit is extremely large, the number of different sorts of patterns needed to make up the IC circuit is not so large. Therefore, pattern sizes needed to finish an LSI circuit, for example, can be checked in circuit design and it is easy to prepare pattern data as shown in Figure 6 in advance, for patterns which need to be exposed in one process. Calculations for deriving the pattern data can be done by the CPU of Figure 5 or by some other calculator, and the data is stored in memory 24a in advance.

Figure 6 relates only to X direction pattern data, but it will be understood that similar calculations and pattern data are necessary for the Y direction. Y direction data is also stored in the memory 24a.

Similar data for other beam sizes (accuracy grades) is prepared and stored in the memories 24b, c and d respectively. The individual accuracy grades and the number of grades can be determined at will.

The capacity of memories 24a, b, c and d may be a few tens of kilobytes for each memory, but of course, this depends on the number of sorts of patterns and the accuracies required.

Returning to Figure 5, first pattern information is read out from buffer memory 23, under control of CPU 22. This information includes accuracy information for a first pattern. In a case in which only coarse accuracy is required (mode 1), a code 01 is specified for that grade. By this code, the memory 24a is accessed. Then, by the pattern size information, an address corresponding to the pattern length is accessed, and pattern data stored in that address is read out.

Similarly, corresponding to accuracy information, modes 2, 3 and 4, for other grades of accuracy, are specified by codes 02, 03 and 04, and memories 23b, c and d are accessed respectively, and corresponding pattern data read out.

Beam size data $S_x$ and $S_y$ read out from the appropriate memory 24 is sent to a correction circuit 25. Correction circuit 25 corrects the beam size to precisely equal 4 μm when the code 01 is specified. For other codes it corrects the beam size accordingly. The circuit also corrects the beam shift caused by a refocussing process.

Corrected X and Y beam size signals are led to digital-analog converters (DAC) 26 and 27 respectively, and converted to respective analog signals. These signals are amplified by amplifiers 28 and 29 respectively, and then supplied respectively to X and Y deflectors of the first deflector 15, as a size signal.

Thus, the size of the beam focussed on the substrate 3 is adjusted to a specified size equal to the maximum size usable for the pattern concerned. Moreover, beam size is adjusted so that no residual parts are left when the pattern is divided by rectangles equal to beam size.

Pitch data $p_x$, $p_y$ and number data $n_x$, $n_y$ included in the pattern data are read out from memory 24 and sent to and stored in a register 30 and an accumulator 31 respectively.

The accumulator 31 provides a signal, for each shot equal to $n_x \times p_x$ and $n_y \times p_y$ in the following manner.

At first $n_x$ and $n_y$ are 0. With each shot $n_x$ is increased by 1, until $n_x$ reaches the number data ($n_x$) of the pattern concerned. Then 1 is added to $n_y$, and then with each shot $n_x$ is reduced by 1. The explosion is repeated until $n_x$ becomes 0. Then, 1 is added to $n_y$ making it 2, and again with each shot $n_x$ is increased by 1. This is repeated with each shot, until $n_x$ and $n_y$ each reach the corresponding number specified by the number data.

At each shot timing, the signals $n_x \times p_x$ and $n_y \times p_y$ are sent to an adder 32. To the adder 32 there are also supplied starting position signals $x_1$ and $y_1$, which are given in the starting position information, from the buffer memory 23. These are added respectively to $n_x \times p_x$ and $n_y \times p_y$, given by the accumulator 31. It will be understood that the resultant added signals provide signals to shift the electron beam step by step to expose the whole area of a pattern by a step and expose process as shown by arrows 7 in Figure 3.

These added signals are supplied to digital-analog converters (DAC) 33 and 34 respectively, and converted to analog signals which are amplified by amplifiers 35 and 36 respectively, and fed to the second deflector 20 of the electron beam exposer as position signals.

In such manner, the electron exposer exposes a first pattern on the substrate with a step and expose process. When the first pattern has been exposed, the CPU commands reading of next pattern information, for the next pattern to be exposed, in the buffer memory 23 of Figure 5. Step and exposure processes are repeated for the next pattern and subsequent patterns with a specified accuracy for each pattern, until all patterns are exposed.

In the above description with reference to Figure 5, only one method for handling residual parts of patterns divided by rectangles equal to beam size has been mentioned. However, the other two methods of handling such residual parts mentioned above can easily be employed. Namely, the majority of a pattern can be exposed using the maximum beam size permitted by the accuracy requirement and then to deal with any residual part, pattern data is altered to provide a single shot or two shots to cover the residual part.

It will be understood that the above described embodiment of the present invention provides for the exposure of an IC substrate with a maximum useable beam size allowable for each pattern. Moreover, calculation time can be eliminated and processing speed increased significantly. In fact, by using this exposure system, the throughput of electron beam exposer is about doubled as compared with prior systems.

**Claims**

1. An electron beam exposure system, in which beam size is varied in accordance with different accuracy requirements of different patterns to be exposed, and each pattern is exposed using a maximum permissible beam size therefor, the system comprising:

a rectangular electron beam exposer provided with

(a) a first mask having a rectangular aperture for restricting an electron stream to form an electron beam having a rectangular cross section;

(b) a first deflector for deflecting the electron beam in accordance with a size signal applied to the first deflector;

(c) a second mask having a rectangular aperture for restricting the electron beam to provide a selected rectangular cross section for the electron beam, corresponding to the size signal applied to the first deflector; and

(d) a second deflector for deflecting the electron beam on a substrate in accordance with position signals applied to the second deflector; and control means operable to provide the electron beam exposer with

(a) the said size signal, in accordance with the accuracy required of a pattern to be exposed; and

(b) the said position signal; such that the electron beam exposes patterns sequentially, the electron beam having a maximum beam size permissible for each pattern,

the control means comprising:

(a) buffer memory means which stores pattern information including accuracy information, starting position information and pattern size information for each pattern;

(b) a plurality of memory means each storing pattern data, including pattern size data, number data, pitch data, and beam size data;

(c) first means for selecting pattern data stored in said memory means in accordance with said accuracy information and said size information in the buffer memory means, for a pattern to be exposed;

(d) second means providing the said size signal in accordance with beam size data included in the pattern data selected by the first means; and

(e) third means providing the said position signal in accordance with pitch data and number data included in the pattern data selected by the first means and starting position information for the pattern stored in the buffer memory means.

2. An electron beam exposure system as set forth in claim 1, in which pattern information for all patterns to be exposed in one process, checked in advance, and pattern data necessary for generating all of those patterns, calculated in advance, are stored in the said memory means.

3. An electron beam exposure system as set forth in claim 1 or 2, in which the pattern data is classified in accordance with accuracy requirements, each of said plurality of memory means storing pattern data for a respective accuracy requirement classification.

4. An electron beam exposure system as set forth in claim 1, 2 or 3, in which the said beam size data, the said number data and the said pitch data are calculated as follows for each pattern to be exposed:

(1) the pattern is divided into rectangles equal to the maximum beam size determined by the accuracy required for the pattern;

(2) if, after such division, there remains a residual area smaller than the maximum beam size, the beam size is adjusted to a new beam size, which is smaller than the maximum beam size, but as large as possible allowing the whole area of the pattern to be divided into equal sized rectangles having a size equal to the new beam size; and

(3) the beam size data is set equal to said new beam size, the pitch data in X and Y directions are set equal to the side lengths of the new beam size respectively, and the number data in X and Y directions are set equal to the numbers of new size rectangles along side edges of the pattern.

5. An electron beam exposure system as set forth in claim 1, 2 or 3, in which the said beam size data, the said pitch data and the said number data for each pattern to be exposed are determined as follows:

(1) the pattern is divided into rectangles equal to the maximum beam size determined by the accuracy required for the pattern;

(2) if, after such division, there remains a residual area smaller than the maximum beam size, the pattern is further divided into a main part which is of a size an integral multiple of the maximum beam size, and a residual part;

(3) for the main part, the said beam size data, the said pitch data and the said number data are set equal to the maximum beam size, a side length of the maximum size beam, and the number of rectangles of the maximum beam size along a side edge of the main part, respectively;

(4) for the residual area, the said beam size data is set equal to the residual area size, and

(5) such determination is carried out in respect of both X and Y directions.

6. An electron beam exposure system as set forth in claim 1, 2 or 3, in which the said beam size data, the said pitch data and the said number data for each pattern to be exposed are determined as follows:

(1) the pattern is divided into rectangles equal to the maximum beam size determined by the accuracy required for the pattern;

(2) if, after such division, there remains a residual area smaller than the maximum beam size, said pattern is divided into a combined portion comprising the residual part and a maximum beam size rectangle adjacent to the residual part, and a main portion comprising the remaining part of the pattern;

(3) for the main portion, the said beam size data, the said pitch data and the said number data are set equal to the maximum beam size, a side length of the maximum sized beam, and the number of rectangles of the maximum beam size along a side edge of the main part, respectively;

(4) for the combined portion, the said beam size data and the said pitch data are set equal to half the size of the combined portion, and the said number data is set to 2; and

(5) such determination is carried out in respect of both X and Y directions.

7. An electron beam exposure system as set forth in any one of claims 1 to 6, in which the control means further comprises a means for effecting an electron beam refocussing process.

**Patentansprüche**

1. Elektronenstrahlbestrahlungssystem, bei dem die Strahlgröße entsprechend unterschiedlichen Genauigkeitsanforderungen von verschiedenen zu bestrahlenden Mustern variiert wird, und jedes Muster unter Verwendung einer maximal dafür zulässigen Strahlengröße bestrahlt wird, welches System umfaßt:

einen rechtwinkligen Elektronenstrahlbestrahler, mit

(a) einer ersten Maske, die eine rechtwinklige Apertur hat, um einen Elektronenstrahl zu begrenzen, um einen Elektronenstrahl zu formen, der einen rechtwinkligen Querschnitt hat;

(b) einem ersten Deflektor, zum Ablenken des Elektronenstrahls in Übereinstimmung mit einem Größensignal, welches dem ersten Deflektor zugeführt wird;

(c) einer zweiten Maske, die eine rechtwinklige Apertur hat, um den Elektronenstrahl zu begrenzen, um einen ausgewählten rechtwinkligen Querschnitt für den Elektronenstrahl zu liefern, welcher dem Größensignal entspricht, das dem ersten Deflektor zugeführt wird; und

(d) einem zweiten Deflektor zum Ablenken des Elektronenstrahls auf ein Substrat in Übereinstimmung mit Positionssignalen, welche dem zweiten Deflektor zugeführt werden; und

Steuereinrichtungen, die betreibbar sind, um den Elektronenstrahlbestrahler zu versehen mit

(a) dem genannten Größensignal, in Übereinstimmung mit der Genauigkeit, die für ein zu bestrahlendes Muster erforderlich ist; und

(b) dem genannten Positionsignal; so daß der Elektronenstrahl sequentiell Muster bestrahlt, wobei der Elektronenstrahl für jedes Muster eine maximal zulässige Strahlgröße hat, und

die Steuereinrichtung umfaßt:

(a) Pufferspeichereinrichtungen, welche Musterinformation speichern, einschließlich der Genauigkeitsinformation, der Startpositionsinformation und der Mustergrößeninformation für jedes Muster;

(b) eine Vielzahl von Speichereinrichtungen, die jeweils Musterdaten speichern, einschließlich Mustergrößendaten, Anzahldaten, Teilungsdaten und Strahlgrößendaten;

(c) erste Einrichtungen zum Auswählen von Musterdaten für ein zu bestrahlendes Muster, die in den genannten Speichereinrichtungen gespeichert sind, in Übereinstimmung mit der Genauigkeitsinformation und der genannten Größeninformation in den Pufferspeichereinrichtungen;

(d) zweite Einrichtungen, welche das genannte Größensignal liefern, in Übereinstimmung mit Strahlgrößendaten, die in den Musterdaten enthalten sind, welche von der ersten Einrichtung ausgewählt werden; und

(e) dritte Einrichtungen, die das genannte Positionssignal in Übereinstimmung mit den Teilungsdaten und den Anzahldaten auswählen, die in den Musterdaten enthalten sind, welche von der ersten Einrichtung ausgewählt werden, und Startpositionsinformation für die Muster, die in dem Pufferspeicher gespeichert sind.

2. Elektronenstrahlbestrahlungssystem nach Anspruch 1, bei dem die Musterinformation für alle Muster, die in einem Verfahren bestrahlt werden sollen, im voraus geprüft wird, und Musterdaten, die zur Erzeugung all jener Muster erforderlich sind, die im voraus berechnet werden, in den genannten Speichereinrichtungen gespeichert werden.

3. Elektronenstrahlbestrahlungssystem nach Anspruch 1 oder 2, bei dem die Musterdaten in Übereinstimmung mit den Genauigkeitserfordernissen klassifiziert werden, wobei jede der genannten Vielzahl von Speichereinrichtungen Musterdaten für eine entsprechende Genauigkeitsforderlichkeitsklassifikation speichert.

4. Elektronenstrahlbestrahlungssystem nach Anspruch 1, 2 oder 3, bei dem die genannten Strahlgrößendaten, die genannten Anzahldaten und die genannten Teilungsdaten für das zu bestrahlende Muster wie folgt berechnet werden:

(1) das Muster wird in Rechtecke unterteilt, die gleich der maximalen Strahlgröße sind, die durch das Genauigkeitserfordernis für das Muster bestimmt wird;

(2) falls, nach solch einer Teilung, ein Restbereich verbleibt, der kleiner als die maximale Strahlgröße ist, wird die Strahlgröße auf eine neue Strahlgröße justiert, die kleiner als die maximale Strahlgröße ist, aber so groß wie möglich ist, um zu erlauben, daß die gesamte Fläche des Musters in gleich große Rechtecke unterteilt wird, die eine Größen haben, die gleich der neuen Strahlgröße ist; und

(3) die Strahlgrößendaten werden mit der genannten neuen Strahlgröße gleichgesetzt, die Teilungsdaten in X- und Y-Richtung werden gleich den jeweiligen Seitenlängen der neuen Strahlgrößen geteilt, und die Anzahldaten in X- und Y-Richtung werden den Anzahlen der Rechtecke der neuen Größe längs den Seitenkanten des Musters gleichgesetzt.

5. Elektronenstrahlbestrahlungssystem nach Anspruch 1, 2 oder 3, bei dem die genannten Strahlgrößendaten, die genannten Teilungsdaten und die genannten Anzahldaten für jedes zu bestrahlende Muster wie folgt bestimmt werden:

(1) das Muster wird in Rechtecke unterteilt, die gleich der maximalen Strahlgröße sind, die durch das Genauigkeitserfordernis für das Muster bestimmt ist;

(2) falls, nach solch einer Teilung, ein Restbereich verbleibt, der kleiner als die maximale Strahlgröße ist, wird das Muster ferner in einen Hauptteil unterteil, welcher von der Größe eines ganzzahligen Vielfachen der maximalen Strahlgröße ist, und in einen Restteil;

(3) für den Hauptteil werden die genannten Strahlgrößendaten, die genannten Teilungsdaten und die genannten Anzahldaten gleich der maximalen Strahlgröße, einer Seitenlänge der maximalen Strahlgröße bzw. der Anzahl der Rechtecke der maximalen Strahlgröße längs einer Seitenkante des Hauptteils gesetzt;

(4) für den restlichen Bereich werden die genannten Strahlgrößendaten gleich der Restbereichgröße gesetzt, und

(5) solch eine Bestimmung wird in Bezug auf sowohl die X- als auch die Y-Richtung durchgeführt.

6. Elektronenstrahlbestrahlungssystem nach Anspruch 1, 2 oder 3, bei dem die genannten Strahlgrößendaten, die genannten Teilungsdaten und die genannten Anzahldaten für jedes Muster, das bestrahlt werden soll, wie folgt bestimmt werden:

(1) das Muster wird in Rechtecke unterteil, die gleich der maximalen Strahlgröße sind, die durch die Genauigkeit bestimmt wird, die für das Muster erforderlich ist;

(2) falls, nach solch einer Teilung, ein Restbereich verbleibt, der kleiner als die maximale Strahlgröße ist, wird das genannte Muster in einen kombinierten Abschnitt unterteilt, der den Restteil und ein maximales Strahlgrößenrechteck umfaßt, welches dem Restteil benachbart ist, und einen Hauptabschnitt, der den verbleibenden Teil des Musters umfaßt;

(3) für den Hauptabschnitt werden die Strahlgrößendaten, die genannten Teilungsdaten und die genannten Anzahldaten gleich der maximalen Strahlgröße, einer Seitenlänge der maximalen Strahlgröße bzw. der Anzahl von Rechtecken der maximalen Strahlgröße längs einem Seitenrand des Hauptteils gleichgesetzt;

(4) für den kombinierten Abschnitt werden die genannten Strahlgrößendaten und die genannten Teilungsdaten gleich der halben Größe des kombinierten Abschnitts gesetzt und die genannten Anzahldaten werden auf 2 gesetzt; und

(5) solch eine Bestimmung wird sowohl in Bezug auf die X- als auch auf die Y-Richtung durchgeführt.

7. Elektronenstrahlbestrahlungssystem nach einem der Ansprüche 1 bis 6, bei dem die Steuereinrichtung ferner eine Einrichtung zum Bewirken eines Elektronenstrahl-Refokussierungsverfahrens umfaßt.

**Revendications**

1. Système d'exposition par un faisceau d'électrons, dans lequel la grosseur d'un faisceau est modifiée en fonction de différents impératifs de précision des différentes configurations à exposer et chaque configuration est exposée en utilisant une grosseur de faisceau maximale permise pour elle, le système comportant:

un appareil d'exposition par un faisceau d'électrons rectangulaire comportant:

(a) un premier masque avec une ouverture rectangulaire pour limiter un faisceau d'électrons afin de former un faisceau d'électrons ayant une section transversale rectangulaire;

(b) un premier déflecteur destiné à dévier le faisceau d'électrons en fonction d'un signal de grosseur appliqué au premier déflecteur;

(c) un second masque avec une ouverture rectangulaire pour limiter le faisceau d'électrons et produire une section transversale rectangulaire sélectionnée de ce faisceau d'électrons correspondant au signal de grosseur appliqué au premier déflecteur; et

(d) un second déflecteur destiné à dévier le faisceau d'électrons sur un substrat en fonction de signaux de position appliqués au second déflecteur;

et un dispositif de commande ayant pour fonction de fournir à l'appareil d'exposition par un faisceau d'électrons:

(a) ledit signal de grosseur en fonction de la précision requise d'une configuration à exposer; et (b) ledit signal de position; de manière que le faisceau d'électrons expose séquentiellement des configurations, le faisceau d'électrons ayant une grosseur de faisceau maximale permise pour chaque configuration,

le dispositif de commande comportant:

(a) une mémoire tampon qui mémorise des informations de configuration comprenant des informations de précision, des informations de position de départ et des informations de dimension de configuration pour chaque configuration;

(b) plusieurs mémoires mémorisant chacune des données de configuration comprenant des données de dimension de configuration, des données de nombre, des données de pas et des données de grosseur de faisceau;

(c) un premier dispositif de sélection des données de configuration mémorisées dans lesdites mémoires en fonction desdites informations de précision et desdites informations de grosseur dans ladite mémoire tampon pour une configuration à exposer,

(d) un second dispositif produisant ledit signal de grosseur en fonction des données de grosseur de faisceau incluses dans les données de configuration sélectionnées par le premier dispositif; et

(e) un troisième dispositif produisant ledit signal d'exposition en fonction des données de pas et des données de nombre incluses dans les données de configuration sélectionnées par le premier dispositif et des informations de positions de départ pour la configuration mémorisées dans la mémoire tampon.

2. Système d'exposition par un faisceau d'électrons selon la revendication 1, dans lequel des informations de configuration pour toutes les configurations à exposer dans une opération, contrôlées à l'avance et des données de configuration nécessaires pour produire toutes ces configurations, calculées à l'avance, sont mémorisées dans lesdites mémoires.

3. Système d'exposition par un faisceau d'électrons selon la revendication 1 ou 2, dans lequel les données de configuration sont placées en fonction des conditions de précision, chacune desdites plusieurs mémoires mémorisant des données de configuration pour une classification respective de condition de précision.

4. Système d'exposition par un faisceau d'électrons selon la revendication 1, 2 ou 3 dans lequel lesdites données de grosseur de faisceau lesdites données de nombre et lesdites données de pas sont calculés de la manière suivante pour chaque configuration à exposer:

(1) la configuration est divisée en des rectangles égaux à la grosseur maximale du faisceau déterminée par la précision requise pour la configuration;

(2) si, après cette division, il reste une surface résiduelle plus petite que la grosseur maximale du faisceau, la grosseur du faisceau est réglée à une nouvelle grosseur de faisceau qui est inférieure à la grosseur maximale du faisceau mais aussi grande que possible permettant que toute la surfaec de la configuration soit divisée en des rectangles de mêmes dimensions ayant une dimension égale à la nouvelle grosseur du faisceau; et

(3) les données de grosseur du faisceau sont établies égales à la nouvelle grosseur de faisceau, les données de pas dans les directions X et Y sont établies égales au longueurs latérales de la nouvelle grosseur de faisceau respectivement et les données de nombre dans les directions X et Y sont établies égales aux nombres de rectangles de nouvelle dimension le long des bords latéraux de la configuration.

5. Système d'exposition par un faisceau d'électrons selon la revendication 1, 2 ou 3 dans lequel lesdites données de grosseur de faisceau, lesdites données de pas et lesdites données de nombre pour chaque configuration à exposer sont déterminées de la manière suivante:

(1) la configuration est divisée en des rectangles égaux à la grosseur maximale du faisceau, déterminée par la précision requise pour la configuration,

(2) si, après cette division, il subsiste une surface résiduelle plus petite que la grosseur maximale du faisceau, la configuration est à nouveau diffusée en une partie principale qui a une dimension qui est une multiple entier de la grosseur maximale du faisceau et une partie résiduelle;

(3) en ce que concerne la partie principale, lesdites données de grosseur de faisceau lesdites données de pas et lesdites données de nombre sont établies égales à la grosseur maximale du faisceau, à une longueur latérale de la dimension maximale du faisceau et au nombre de rectangles de la dimension maximale du faisceau le long d'un bord latéral de la partie principale respectivement;

(4) en ce qui concerne la surface résiduelle, lesdites données de grosseur de faisceau sont établies égales à la dimension de surface résiduelle, et

(5) cette détermination est effectuée à la fois pour les directions X et Y.

6. Système d'exposition par un faisceau d'électrons selon la revendication 1, 2 ou 3, dans lequel lesdites données de grosseur de faisceau, lesdites données de pas et lesdites données de nombre pour chaque configuration à exposer sont déterminées de la manière suivante:

(1) la configuration est divisée en des rectangles égaux à la grosseur maximale du faisceau déterminée par la précision requise pour la configuration;

(2) si, après cette division, il subsiste une surface résiduelle plus petite que la grosseur maximale du faisceau, ladite configuration est divisée en une partie combinée comprenant la partie résiduelle et un rectangle de dimension maximale du faisceau voisin de la partie résiduelle et une partie principale comportant la partie qui reste de la configuration;

(3) en ce que concerne la partie principale,

**0 104 922**

lesdites données de grosseur de faisceau, lesdites données de pas et lesdites données de nombre sont établies égales à la grosseur maximale du faisceau, à une longueur latérale du faisceau de dimension maximale et au nombre des rectangles de la grosseur maximale le long d'un bord latéral de la partie principale respectivement;

(4) en ce que concerne la partie combinée, lesdites données de grosseur de faisceau et lesdites données de pas sont établies égales à la moitié de la dimension de la partie combinée et lesdites données de nombre sont établies à deux; et

(5) cette détermination est effectuée à la fois pour les directions X et Y.

7. Système d'exposition par un faisceau d'électrons selon l'une quelconque des revendications 1 à 6, dans lequel le dispositif de commande comporte en outre un dispositif qui effectue une opération de refocalisation du faisceau d'électrons.

Fig 1

Fig 2

Fig 3

Fig 4

Fig 5

| PATTERN SIZE ($l_x$) | NUMBER ($n_x$) | PITCH ($p_x$) | BEAM SIZE ($S_x$) |
|---|---|---|---|
| 0.0 5 $\mu$ | 1 | ———— | 0.0 5 $\mu$ |
| 0.1 0 | 1 | ———— | 0.1 0 |
| 0.1 5 | 1 | ———— | 0.1 5 |
| 0.2 0 | 1 | ———— | 0.2 0 |
| . | . | . | . |
| . | . | . | . |
| . | . | . | . |
| 3.9 5 | 1 | ———— | 3.9 5 |
| 4.0 0 | 1 | ———— | 4.0 0 |
| 4.0 5 | 2 | 2.0 2 5 $\mu$ | 2.0 5 |
| 4.1 0 | 2 | 2.0 5 | 2.0 5 |
| 4.1 5 | 2 | 2.0 7 5 | 2.1 0 |
| . | . | . | . |
| . | . | . | . |
| . | . | . | . |
| 7.9 5 | 2 | 3.9 7 5 | 4.0 0 |
| 8.0 0 | 2 | 4.0 0 | 4.0 0 |
| 8.0 5 | 3 | 2.6 8 3 3 3 | 2.7 0 |
| → 8.1 0 | 3 | 2,7 0 | 2.7 0 |
| . | . | . | . |
| . | . | . | . |
| . | . | . | . |
| 1 1.9 5 | 3 | 3.9 8 3 3 3 | 4.0 0 |
| 1 2.0 0 | 3 | 4.0 | 4.0 0 |
| 1 2.0 5 | 4 | 3.0 1 2 5 | 3.0 5 |
| 1 2.1 0 | 4 | 3.0 2 5 | 3.0 5 |
| . | . | . | . |
| . | . | . | . |
| . | . | . | . |
| 9 9.9 5 | 2 5 | 3.9 9 8 | 4.0 0 |
| 1 0 0.0 0 | 2 5 | 4.0 0 | 4.0 0 |

*Fig 6*